Europäisches Patentamt

European Patent Office

Office européen des brevets

(19)

(11) **EP 0 691 747 B1**

(12) **EUROPÄISCHE PATENTSCHRIFT**

(45) Veröffentlichungstag und Bekanntmachung des Hinweises auf die Patenterteilung:
**14.03.2001 Patentblatt 2001/11**

(51) Int Cl.⁷: **H03L 7/22**

(21) Anmeldenummer: **95110276.3**

(22) Anmeldetag: **01.07.1995**

(54) **Schaltungsanordnung für eine Phasenregelschleife**

Circuit arrangement for a phase locked loop

Dispositif de circuit pour une boucle de synchronisation de phase

(84) Benannte Vertragsstaaten:
**DE FR GB IT**

(30) Priorität: **08.07.1994 DE 4424012**

(43) Veröffentlichungstag der Anmeldung:
**10.01.1996 Patentblatt 1996/02**

(73) Patentinhaber: **ATMEL Germany GmbH**
**74072 Heilbronn (DE)**

(72) Erfinder:
• **Kröbel, Hans-Eberhard**
**D-74080 Heilbronn (DE)**
• **Rinderle, Heinz**
**D-74080 Heilbronn (DE)**

• **Sapotta, Hans, Dr.**
**D-74078 Heilbronn (DE)**
• **Nutz, Werner**
**D-74080 Heilbronn (DE)**

(74) Vertreter: **Maute, Hans-Jürgen, Dipl.-Ing. et al**
**Daimler-Benz Aktiengesellschaft,**
**FTP/H,**
**Postfach 35 35**
**74025 Heilbronn (DE)**

(56) Entgegenhaltungen:
**EP-A- 0 560 525       FR-A- 2 612 028**
**JP-A- 54 156 409      US-A- 5 122 677**

**Beschreibung**

Phasenregelschleifen (PLLs) werden in der Schaltungstechnik - insbesondere in der Telekommunikation und der Rundfunktechnik - immer häufiger eingesetzt, da sich hiermit frequenzselektive Vorgänge relativ einfach durchführen lassen. Bei PLLs wird mit Hilfe eines Referenzeingangs, eines Phasenkomparators (Phasendetektor mit Ladungspumpe), eines Schleifenfilters mit Regelverstärker, eines Oszillators (VCO) und eines Frequenzteilers eine Ausgangsfrequenz in eine phasenstarre Beziehung zu einer am Referenzeingang anliegenden Referenzfrequenz gesetzt; durch Variation der Teilerfaktoren des Frequenzteilers kann der VCO abgestimmt und dadurch die (stabile) Ausgangsfrequenz mit einer bestimmten (vorgebbaren) Schrittweite gerastert werden.

Für viele Anwendungsfälle werden PLL-Schaltungen benötigt, die einerseits sehr schnell von einer Ausgangsfrequenz auf eine alternative Frequenz umschalten können (hohe Umschaltgeschwindigkeit) und bei denen andererseits ein Frequenzwechsel mit kleiner Schrittweite möglich ist. Beispielsweise bei Rundfunkempfängerninsbesondere von Radiogeräten mit Sendersuchlauf oder mit RDS - muß der Empfänger exakt und sehr schnell auf die unterschiedlichen Alternativfrequenzen des jeweiligen Senders eingestellt werden können; diese Alternativfrequenzen liegen in Deutschland im 100 kHz-Raster über das UKW-Band (87,5 MHz ... 108 MHz) verteilt. Da aber das Frequenzraster direkt von der höchstmöglichen Referenzfrequenz abhängt, dieses wiederum aber die Einschwingzeit bei einem Frequenzwechsel bestimmt, sind die Möglichkeiten derartiger PLL-Schaltungen beschränkt.

Um kürzere Sprungzeiten beim Frequenzwechsel zu ermöglichen, wird beim sogenannten DDS-Verfahren ("Direkte Digitale Synthese") die Oszillatorfrequenz bzw. die Referenzfrequenz direkt digital generiert. Nachteilig hierbei ist der hohe Schaltungsaufwand und Flächenbedarf (verbunden mit hohen Kosten), der große Leistungsbedarf und das Fehlen einer Abstimmspannung, mit der die anderen frequenzselektiven Schaltungsteile der Gesamtschaltung analog zum VCO mitabgestimmt werden können.

Die Druckschrift JP-A-54 156 409 offenbart alle Merkmale des Oberbegriffs des Anspruchs 1.

Der Erfindung liegt die Aufgabe zugrunde, eine einfache Schaltungsanordnung für eine Phasenregelschleife anzugeben, die die genannten Nachteile vermeidet und die vorteilhafte Eigenschaften, insbesondere bezüglich der Geschwindigkeit und der Schrittweite des Frequenzwechsels aufweist.

Diese Aufgabe wird erfindungsgemäß durch die Merkmale im Kennzeichen des Patentanspruchs 1 gelöst.

Vorteilhafte Weiterbildungen der Erfindung ergeben sich aus den Unteransprüchen.

Die vorgestellte Schaltungsanordnung enthält neben einem PLL-Hauptschaltungsteil zur Erzeugung und Ausgabe einer abstimmbaren rasterbaren Ausgangsfrequenz mindestens zwei PLL-Hilfsschaltungsteile zur Generierung von Referenzfrequenzen für den PLL-Hauptschaltungsteil und somit zur Vorgabe der Schrittweite und der nächsten Ausgangsfrequenz des PLL-Hauptschaltungsteils, sowie einen Schaltungsteil zur Erzeugung der Referenzfrequenz(en) für die PLL-Hilfsschaltungsteile; zusätzlich kann noch eine Auswerteschaltung zur Überwachung des Frequenzwechsels vorgesehen werden.

Die PLL-Schaltungsteile (PLL-Hauptschaltungsteil und PLL-Hilfsschaltungsteile) bestehen jeweils aus einem Phasendetektor, einer Ladungspumpe, einem Schleifenfilter, einem Oszillator (VCO) sowie einem Frequenzteiler. Der Phasendetektor steuert die Ladungspumpe über Schaltspannungen an seinen Ausgängen "digital" an; die Ströme der Ladungspumpe werden so geschaltet, daß sich der PLL-Schaltungsteil stets im eingerasteten Zustand befindet. Das Schleifenfilter (beispielsweise ein Tiefpaßfilter) zwischen Ladungspumpe und Oszillator dient zur Unterdrückung von Störungen der Ladungspumpe und zur Gewährleistung der Stabilität der PLL-Schaltung. Am Ausgang des Schleifenfilters steht die jeweilige Abstimmspannung für den VCO zur Verfügung, dessen Ausgangssignal die phasenstabile Ausgangsfrequenz bildet; diese Ausgangsfrequenz wird wiederum dem Phasendetektor zugeführt und durch diese Rückkoppelschleife die Ausgangsfrequenz der PLL-Schaltungsteile fest "eingerastet". Die PLL-Hilfsschaltungsteile weisen einen, jeweils mit einem Eingang des Phasendetektors verbundenen, variablen Frequenzteiler zur Generierung der jeweiligen Referenzfrequenz und vorzugsweise zusätzlich einen "Lock"-Detektor zur Erkennung des "eingerasteten" (phasenstabilen) Zustands des PLL-Hilfsschaltungsteils auf; der PLL-Hauptschaltungsteil weist einen mit einem der beiden Eingänge des Phasendetektors verbundenen festen oder umschaltbaren Frequenzteiler sowie zusätzlich ein mit dem anderen Eingang des Phasendetektors verbundenes und ggf. von der Auswerteschaltung angesteuertes Umschaltglied auf.

Die von den PLL-Hilfsschaltungsteilen jeweils als Ausgangssignal generierten stabilen Referenzfrequenzen werden dem die eigentliche Oszillatorfrequenz ausgebenden PLL-Hauptschaltungsteil als Alternativfrequenzen zur Verfügung gestellt; je nach Bedarf kann über das Umschaltglied des PLL-Hauptschaltungsteils zwischen den verschiedenen stabilen Alternativfrequenzen sehr schnell umgeschaltet werden - der Umschaltvorgang kann durch die Auswerteschaltung dahingehend beeinflußt werden, daß ein Umschalten auf eine andere Frequenz nur dann ermöglicht wird, wenn diese Alternativfrequenz frequenzstabil und phasenstabil vorliegt. Den verschiedenen PLL-Hilfsschaltungsteilen werden unterschiedliche Frequenzbereiche der Ausgangsfrequenz zugeordnet, um eine etwaige gegenseitige störende Beeinflussung dieser Frequenzen beim Frequenzwechsel zu verhindern.

Durch die beschriebene Voreinstellung der Alternativfrequenzen wird die PLL-Schaltungsanordnung - je nach den speziellen Erfordernissen - durch entsprechende Variation der PLL-Hilfsschaltungsteile hinsichtlich schnellen Schaltverhaltens und gewünschter Schrittweite optimiert. Weiterhin ist wegen der einfachen Ausführung der PLL-Schaltungsteile eine gute und kostengünstige Integrierbarkeit der PLL-Schaltungsanordnung mit einem geringen Bedarf an Schaltungsmitteln und Chipfläche gegeben.

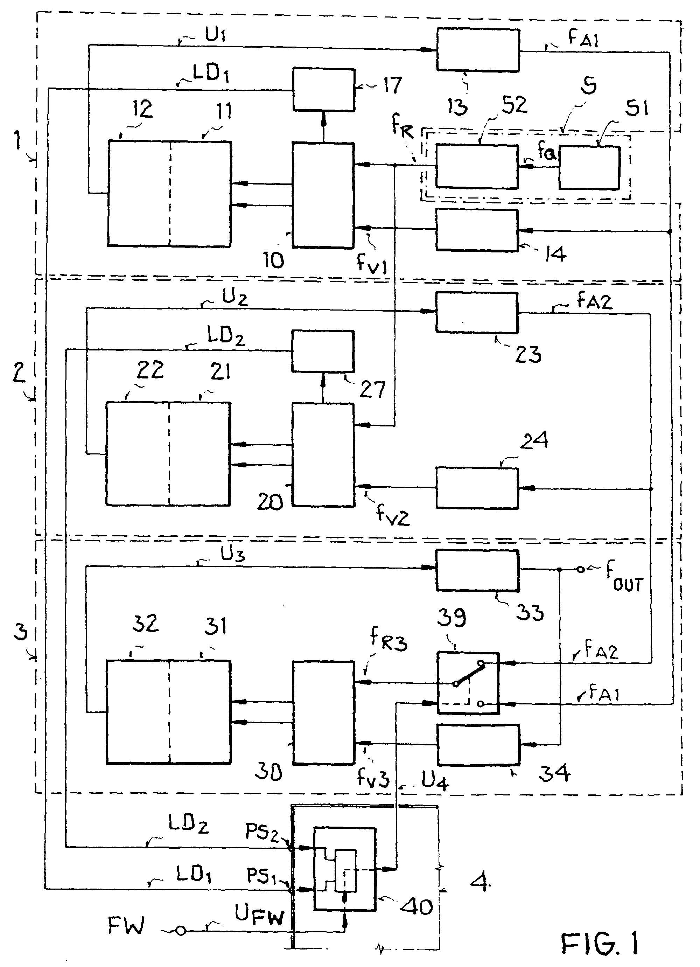

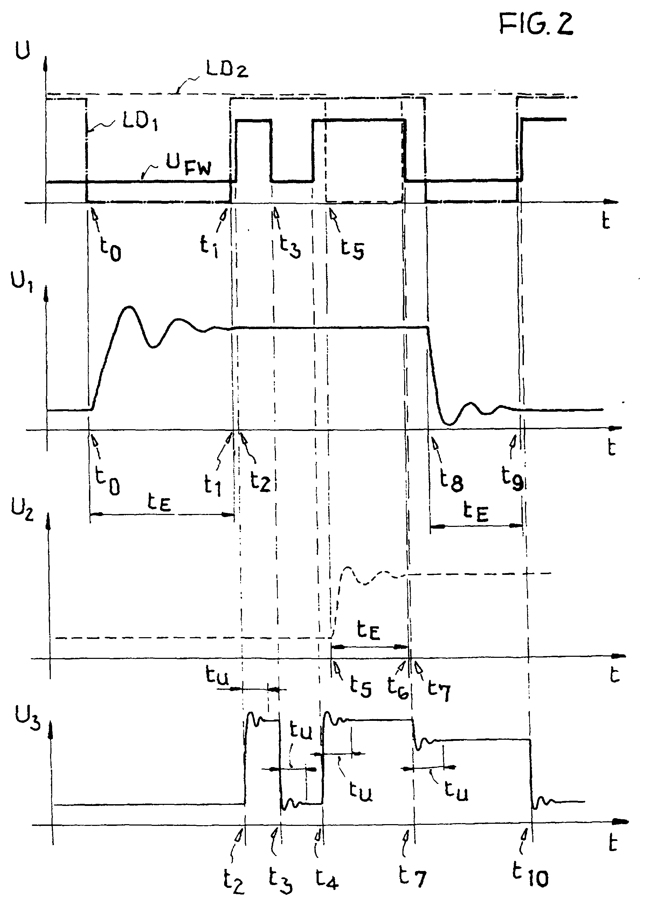

Anhand der Figuren 1 und 2 wird die Schaltungsanordnung der Phasenregelschleife näher beschrieben, wobei in der Figur 1 ein Blockschaltbild für das Ausführungsbeispiel zweier PLL-Hilfsschaltungsteile und in der Figur 2 ein Zeitdiagramm zur Erläuterung der Ablaufsteuerung dargestellt ist.

Die beispielsweise in einem Rundfunkempfänger eingesetzte PLL-Schaltungsanordnung der Figur 1 zur schnellen Umschaltung zwischen zwei Alternativfrequenzen besteht aus einem PLL-Hauptschaltungsteil 3 zur Ausgabe der Oszillatorfrequenz $f_{OUT}$, einem ersten PLL-Hilfsschaltungsteil 1 und einem zweiten PLL-Hilfsschaltungsteil 2 zur Generierung von Referenzfrequenzen $f_{A1}$, $f_{A2}$ für den PLL-Hauptschaltungsteil 3, einem Schaltungsteil 4 als Auswerteschaltung und einem Referenz-Schaltungsteil 5 zur Vorgabe der Referenzfrequenz $f_R$ für die PLL-Hilfsschaltungsteile 1, 2.

Durch den Referenz-Schaltungsteil 5 mit dem Quarzoszillator 51 (Quarzfrequenz $f_Q$) und dem variablen Frequenzteiler 52 wird eine Referenzfrequenz $f_R$ erzeugt und den PLL-Hilfsschaltungsteilen 1, 2 bereitgestellt (beispielsweise wird durch Variation des Teilerfaktors des Frequenzteilers 52 aus der Frequenz $f_Q$ des Quarzoszillators 51 von 4 MHz eine Referenzfrequenz $f_R$ von 2,5 kHz oder 5 kHz oder 10 kHz oder 20 kHz erzeugt; diese Referenzfrequenz $f_R$ multipliziert mit dem Teilerfaktor des Frequenzteilers im PLL-Hauptschaltungsteil 3 ergibt die Schrittweite des PLL-Hauptschaltungsteils 3. Durch den ersten PLL-Hilfsschaltungsteil 1 wird eine erste definierte Ausgangsfrequenz $f_{A1}$ generiert und dem ersten Eingang des Umschaltglieds 39 des PLL-Hauptschaltungsteils 3 als erste Referenzfrequenz zugeführt: hierzu wird die gleichzeitig dem variablen Frequenzteiler 14 zugeführte Ausgangsfrequenz $f_{A1}$ des VCOs 13 durch diesen in die Vergleichsfrequenz $f_{V1}$ heruntergeteilt, die Vergleichsfrequenz $f_{V1}$ im Phasendetektor 10 mit der vom Referenz-Schaltungsteil 5 bereitgestellten Referenzfrequenz $f_R$ verglichen und das Ergebnis dieses Phasenvergleichs über die Steuerausgänge des Phasendetektors 10 der Ladungspumpe 11 bzw. dem Schleifenfilter 12 zugeführt, dessen Ausgangssignal (Abstimmspannung $U_1$) die Ausgangsfrequenz $f_{A1}$ des VCOs 13 nachregelt. Über den ersten Lock-Detektor 17 werden die Phasenabweichungen des Phasendetektors 10 erfaßt; am Ausgang des Lock-Detektors 17 wird ein digitales Ausgangssignal $LD_1$ abhängig davon ausgegeben, ob der erste PLL-Schaltungsteil 1 phasenstarr arbeitet (eingerastet ist) oder nicht.

Durch den völlig unabhängig vom ersten PLL-Hilfsschaltungsteil 1 einstellbaren zweiten PLL-Hilfsschaltungsteil 2 wird eine zweite definierte Ausgangsfrequenz $f_{A2}$ generiert und dem zweiten Eingang des Umschaltglieds 39 des PLL-Hauptschaltungsteils 3 als zweite Referenzfrequenz zugeführt: hierzu wird die Ausgangsfrequenz $f_{A2}$ des VCOs 23 gleichzeitig dem variablen Frequenzteiler 24 zugeführt und durch diesen in die Vergleichsfrequenz $f_{V2}$ heruntergeteilt, das Ausgangssignal des variablen Frequenzteilers 24 (geteilte Vergleichsfrequenz $f_{V2}$) im Phasendetektor 20 mit der Referenzfrequenz $f_R$ des Referenz-Schaltungsteils 5 verglichen und das Ergebnis dieses Phasenvergleichs über die Steuerausgänge des Phasendetektors 20 der Ladungspumpe 21 bzw. dem Schleifenfilter 22 zugeführt, dessen Ausgangssignal (Abstimmspannung $U_2$) den VCO 23 steuert und somit die Ausgangsfrequenz $f_{A2}$ nachregelt; gleichzeitig wird das Ergebnis des Phasenvergleichs vom zweiten Lock-Detektor 27 ausgewertet, an dessen digitalem Ausgangssignal $LD_2$ erkennbar ist, ob der zweite PLL-Schaltungsteil 2 phasenstarr arbeitet.

Der PLL-Hauptschaltungsteil 3 gibt als Ausgangsfrequenz $f_{OUT}$ die gewünschte Frequenz der Phasenregelschleife aus - beispielsweise für den FM-Rundfunkempfang im Bereich $f_{OUT}$ = 98,200 MHz bis $f_{OUT}$ = 118,700 MHz; die Referenzfrequenzen werden von den beiden PLL-Hilfsschaltungsteilen 1 und 2 vorgegeben und von diesen gleichzeitig die minimalen Schrittweiten für den Frequenzwechsel der Ausgangsfrequenz $f_{OUT}$ festgelegt. Die Ausgangsfrequenz $f_{OUT}$ wird dem festen Frequenzteiler 34 zugeführt (Teilerfaktor $N_{34}$) und durch diesen in die Vergleichsfrequenz $f_{V3}$ heruntergeteilt; das Ausgangssignal des festen Frequenzteilers 34 (Vergleichsfrequenz $f_{V3}$ = $f_{OUT}$ : $N_{34}$) wird dem Phasendetektor 30 zugeführt, dort je nach Schalterstellung des Umschaltglieds 39 entweder mit der im PLL-Hilfsschaltungsteil 1 erzeugten Referenzfrequenz $f_{A1}$ oder mit der im PLL-Hilfsschaltungsteil 2 erzeugten Referenzfrequenz $f_{A2}$ verglichen und das Ergebnis dieses Phasenvergleichs über die Steuerausgänge des Phasendetektors 30 der Ladungspumpe 31 bzw. dem Schleifenfilter 32 zugeführt, dessen Ausgangssignal als Abstimmspannung $U_3$ den VCO 33 und damit die Ausgangsfrequenz $f_{OUT}$ nachregelt.

Die beiden digitalen Ausgangssignale $LD_1$ bzw. $LD_2$ der Lock-Detektoren 17 bzw. 27 werden zur Auswertung den beiden Steuereingängen $PS_1$ bzw. $PS_2$ der Auswerteschaltung 4 zugeführt: ein durch Anlegen der Schaltspannung $U_{FW}$ am Schalteingang FW signalisierter Wunsch nach einem Frequenzwechsel der Ausgangsfrequenz $f_{OUT}$ führt nur dann zu einer Umschaltung der Referenzfrequenz $f_{R3}$ auf eine der Alternativfrequenzen $f_{A1}$ oder $f_{A2}$, wenn sich der jeweilige PLL-Hilfsschaltungsteil (PLL-Hilfsschaltungsteil 1 für die Ausgangsfrequenz $f_{A1}$, PLL-Hilfsschaltungsteil 2 für die Ausgangsfrequenz $f_{A2}$) im eingerasteten Zustand befindet; hierzu ist in der Auswerteschaltung 4 ein Logikglied 40 vorgesehen, dessen Steuerausgang mit dem Steuereingang des Umschaltglieds 39 verbunden ist, und das diesen bei einem zulässigen Frequenzwechsel mit dem Steuersignal $U_4$ beaufschlagt.

Die Zeit für einen Frequenzwechsel der Ausgangsfrequenz $f_{OUT}$ (beispielsweise ein Sprung von der Frequenz des unteren Bandendes zur Frequenz des oberen Bandendes) hängt u. a. von der Differenz der neuen und der alten Frequenz sowie von der Referenzfrequenz $f_R$ ab und liegt im ms-Bereich. Falls jedoch die neue Frequenz (Alternativfrequenz) bereits im ersten PLL-Hilfsschaltungsteil 1 oder zweiten PLL-Hilfsschaltungsteil 2 voreingestellt bzw. gesetzt wurde, kann der Umschaltvorgang (bei Vorhandensein eines positiven Ausgangssignals $LD_1$ bzw. $LD_2$) mit Hilfe des vom Steuerausgang der Auswerteschaltung angesteuerten Umschaltglieds wesentlich schneller als die Einstellung dieser Alternativfrequenzen selbst bewerkstelligt werden ($\mu$s-Bereich).

Eine Erweiterung der im Ausführungsbeispiel beschriebenen Schaltungsanordnung auf mehr als zwei PLL-Hilfsschaltungsteile - damit verbunden ist die Voreinstellung von mehr als einer Alternativfrequenz - ist bei Verwendung eines Umschaltglieds mit einer der Anzahl der PLL-Hilfsschaltungsteile entsprechenden Zahl an Eingängen leicht möglich; beispielsweise kann bei einer Schaltungsanordnung mit drei PLL-Hilfsschaltungsteilen und damit drei Referenzfrequenzen für den PLL-Hauptschaltungsteil bereits eine zusätzliche zweite Alternativfrequenz voreingestellt werden.

Anhand der in der Figur 2 dargestellten Zeitdiagramme für die Abstimmspannungen $U_1$, $U_2$, $U_3$ der PLL-Schaltungsteile 1, 2, 3 und für die Lock-Detektorsignale $LD_1$, $LD_2$ wird die zeitliche Ablaufsteuerung erläutert (Zeitachse t nicht maßstäblich gezeichnet):

- Zeitpunkt $t_0$: die Ausgangsfrequenz $f_{OUT}$ wird vom zweiten PLL-Hilfsschaltungsteil 2 vorgegeben (phasenstabile Frequenz $f_{A2}$, da Lock-Detektorsignal $LD_2$ auf "High"), der erste PLL-Hilfsschaltungsteil 1 wird auf eine andere Frequenz $f_{A1}$ umgeschaltet (Abstimmspannung $U_1$ auf "High", Lock-Detektorsignal $LD_1$ "Low"); ein Frequenzwechsel ist nicht vorgesehen (Schaltspannung $U_{FW}$ auf "Low").

- Zeitpunkt $t_1$: der Umschaltvorgang des ersten PLL-Hilfsschaltungsteils 1 ist nach der Einstellzeit $t_E$ (beispielsweise $t_E$ = 10 ms) beendet; durch das Lock-Detektorsignal $LD_1$ wird signalisiert, daß die neue Frequenz $f_{A1}$ phasenstabil ist, bzw. daß sich der erste PLL-Hilfsschaltungsteil 1 im eingerasteten Zustand befindet ($LD_1$ auf "High"). Der zweite PLL-Hilfsschaltungsteil 2 und der PLL-Hauptschaltungsteil 3 bleiben unverändert auf ihrer jeweiligen Frequenz ($f_{A2}$, $f_{OUT}$) eingerastet (Schaltspannung $U_{FW}$ noch auf "Low").

- Zeitpunkt $t_2$: durch die am Eingang FW der Auswerteschaltung 4 anliegende Schaltspannung $U_{FW}$ für den Frequenzwechsel erfolgt mittels des Steuersignals $U_4$ eine Betätigung des Umschaltglieds 39 und dadurch die Umschaltung der Ausgangsfrequenz $f_{OUT}$ des PLL-Hauptschaltungsteils 3 von der Frequenz $f_{A2}$ des zweiten PLL-Hilfsschaltungsteils 2 auf die Frequenz $f_{A1}$ desersten PLL-Hilfsschaltungsteils 1; die Ausgangsfrequenz $f_{OUT}$ ist nach der Umschaltzeit $t_U$ (beispielsweise $t_U$ = 10 $\mu$s) phasenstabil auf die Frequenz $f_{A1}$ eingerastet (siehe Abstimmspannung $\mu_3$).

- Zeitpunkt $t_3$: Schaltspannung $U_{FW}$ für den Frequenzwechsel auf "Low" und dadurch Rücksprung zur alten (voreingestellten und phasenstabilen) Frequenz $f_{A2}$.

- Zeitpunkt $t_4$: Schaltspannung $U_{FW}$ für den Frequenzwechsel auf "High" und dadurch Sprung zur (voreingestellten) Frequenz $f_{A1}$.
  Die beiden Umschaltvorgänge zum Zeitpunkt $t_3$ und Zeitpunkt $t_4$ sind mit sehr geringen Zeitverzögerungen möglich ($\mu$s-Bereich), da durch die Lock-Detektorsignale $LD_1$ bzw. $LD_2$ signalisiert wird, daß sich der jeweilige PLL-Hilfsschaltungsteil 1 bzw. 2 noch im "eingerasteten" Zustand befindet; hierdurch ist allein die Schaltzeit des Umschaltglieds 39 und die Einschwingzeit des PLL-Hauptschaltungsteils 3 für die Umschaltzeit $t_U$ maßgebend (diese liegt im $\mu$s-Bereich).

- Zeitpunkt $t_5$: der zweite PLL-Hilfsschaltungsteil 2 wird auf einen anderen Frequenzwert gesetzt (Abstimmspannung $U_2$ auf "High").

- Zeitpunkt $t_6$: die neue Ausgangsfrequenz $f_{A2}$ des zweiten PLL-Hilfsschaltungsteils 2 liegt nach der Einstellzeit $t_E$ (beispielsweise $t_E$ = = 10 ms) phasenstabil an, wie durch das Lock-Detektorsignal $LD_2$ signalisiert wird ($LD_2$ auf "High").

- Zeitpunkt $t_7$: der durch die Schaltflanke der Schaltspannung $U_{FW}$ angeforderte Frequenzwechsel kann nach Freigabe durch das Steuersignal $LD_2$ vorgenommen und die Ausgangsfrequenz $f_{OUT}$ auf den durch den zweiten PLL-Hilfsschaltungsteil 2 vorgegebenen neuen Frequenzwert der Ausgangsfrequenz $f_{A2}$ umgeschaltet werden.

- Zeitpunkt $t_8$: der erste PLL-Schaltungsteil 1 wird auf einen anderen Frequenzwert $f_{A1}$ umgeschaltet (Abstimmspannung $U_1$ auf "Low").

- Zeitpunkt $t_9$: der Umschaltvorgang für den neuen Frequenzwert der Ausgangsfrequenz $f_{A1}$ ist abgeschlossen (Einstellzeit $t_E$ beispielsweise 10 ms); das Lock-Detektorsignal $LD_1$ geht auf "High".

- Zeitpunkt $t_{10}$: der durch die Schaltspannung $U_{FW}$ angeforderte Frequenzwechsel der Ausgangsfrequenz $f_{OUT}$ auf den neuen Frequenzwert der ersten Ausgangsfrequenz $f_{A1}$ kann erfolgen.

Hieraus wird ersichtlich, daß der PLL-Hauptschaltungsteil 3 sehr schnell umschaltbar ist (die Einstellzeiten $t_E$ der PLL-Hilfsschaltungsteile 1, 2 sind deutlich länger als die Umschaltzeiten $t_U$).

Beim Einsatz der Schaltungsanordnung in einem FM-Rundfunkempfangssystem sind beispielsweise folgende Zahlenwerte vorzugeben bzw. einzustellen:

- der PLL-Hauptschaltungsteil 3 liefert die Oszillatorfrequenz $f_{OUT}$ des Tuners in einem Bereich von $f_{OUT}$ = 98,200 MHz bis $f_{OUT}$ = 118,700 MHz.

- für ein schnelles Umschalten der Ausgangsfrequenz $f_{OUT}$ ist eine hohe Referenzfrequenz $f_{R3}$ erforderlich; die Wahl der Referenzfrequenz $f_{R3}$ bestimmt den Teilerfaktor $N_{34}$ des Frequenzteilers 34 durch die Relation $f_{OUT} = f_{R3} \cdot N_{34}$ . Wird beispielsweise der Teilerfaktor $N_{34}$ = 5 gewählt, erhält man für den erforderlichen Bereich der Referenzfrequenz $f_{R3}$ des VCOs 33:

$$f_{R3} = f_{OUT} : N_{34} = 19{,}64 \text{ MHz} \dots 23{,}74 \text{ MHz}.$$

- der erforderliche Frequenzbereich für die Ausgangsfrequenzen $f_{A1}$ bzw. $f_{A2}$ entspricht dem Frequenzbereich für die Referenzfrequenz $f_{R3}$:

$$f_{A1} = f_{A2} = f_{R3} = 19{,}64 \text{ MHz} \dots 23{,}74 \text{ MHz}.$$

- die Schrittweite $f_{SOUT}$ für die Ausgangsfrequenz $f_{OUT}$ wird durch die Schrittweite $f_{S3}$ für die Referenzfrequenz $f_{R3}$ und damit durch die Schrittweite $f_{S1}$ bzw. $f_{S2}$ der Ausgangsfrequenzen $f_{A1}$ bzw. $f_{A2}$ bestimmt und ergibt sich zu:

$$f_{SOUT} = f_{S3} \cdot N_{34},$$

wobei

$$f_{S3} = f_{S1} = f_{S2};$$

da die Schrittweiten $f_{S1}$ bzw. $f_{S2}$ durch die Referenzfrequenz $f_R$ bestimmt werden ($f_{S1} = f_{S2} = f_R$), ergibt sich für die Schrittweite $f_{SOUT}$ :

$$f_{SOUT} = f_R \cdot N_{34}.$$

Beispielsweise erhält man somit bei einer Referenzfrequenz $f_R$ von 5 kHz und dem Teilerfaktor $N_{34}$ = 5 eine Schrittweite $f_{SOUT}$ = 25 kHz für die Ausgangsfrequenz $f_{OUT}$.

- die Teilerfaktoren $N_{14}$ bzw. $N_{24}$ für die variablen Frequenzteiler 14 bzw. 24 werden entsprechend der Variation der Ausgangsfrequenzen $f_{A1}$ bzw. $f_{A2}$ variiert; als maximaler Wert für die Teilerfaktoren $N_{14}$ bzw. $N_{24}$ ergibt sich $N_{14,max} = N_{24,max} = f_{A1, max}/f_R$ = 4748, was durch einen 13 Bit-Zähler realisiert werden kann.

- bei Verwendung eines üblichen 4 MHz-Quarzes zur Generierung der Oszillatorfrequenz $f_Q$ wird für die Erzeugung der Referenzfrequenz $f_R$ von 5 kHz ein 10 Bit-Teiler benötigt.

Um eine gegenseitige Beeinflussung der Ausgangsfrequenzen der verschiedenen PLL-Hilfsschaltungsteile beim Frequenzwechsel eines PLL-Hilfsschaltungsteils durch Mitziehen des VCOs der jeweils anderen PLL-Hilfsschaltungsteile zu vermeiden, können diesen Ausgangsfrequenzen durch Variation des Teilerfaktors des variablen Frequenzteilers des Referenz-Schaltungsteils, der Teilerfaktoren der variablen Frequenzteiler der PLL-Hilfsschaltungsteile und des Teilerfaktors des Frequenzteilers des PLL-Hauptschaltungsteils unterschiedliche Frequenzbereiche zugeordnet werden. Der Frequenzteiler des PLL-Hauptschaltungsteils muß hierzu ein variierbares Teilerverhältnis aufweisen, wobei eine Umschaltung zwischen den einzelnen PLL-Hilfsschaltungsteilen zugeordneten Teilerfaktoren des Frequenzteilers durch das Umschaltglied gesteuert wird. Weiterhin müssen dann den einzelnen PLL-Hilfsschaltungsteilen vom Referenz-Schaltungsteil unterschiedliche Referenzfrequenzen zugeführt werden, damit die Schrittweite der Ausgangsfrequenz des PLL-Hauptschaltungsteils auch bei Variation des Teilerfaktors von dessen umschaltbarem Frequenzteiler gleich groß bleibt. Hierzu weist der Referenz-Schaltungsteil entweder einen umschaltbaren Frequenzteiler oder dem variablen Frequenzteiler in einer Verzweigung nachgeschaltete Frequenzteiler auf (für jeden PLL-Hilfsschaltungsteil einen Frequenzteiler), durch deren Teilerfaktoren die jeweils erforderliche Referenzfrequenz für die PLL-Hilfsschaltungsteile erzeugt werden. Im obigen Ausführungsbeispiel der zwei PLL-Hilfsschaltungsteile 1, 2 wird für den angegebenen Frequenzbereich der Ausgangsfrequenz $f_{OUT}$ von $f_{OUT}$ 98,200 MHz ... 118,700 MHz beispielsweise der ersten Ausgangsfrequenz $f_{A1}$ ein Teilerfaktor $N_{34}$ = 4 zugeordnet (Frequenzbereich für $f_{A1}$ = 24,55 MHz ... 29,675 MHz) und der zweiten Ausgangsfrequenz $f_{A2}$ ein Teilerfaktor $N_{34}$ = 5 zugeordnet (Frequenzbereich für $f_{A2}$ = 19,64 MHz ... 23,740 MHz). Die Referenzfrequenzen für den ersten PLL-Hilfsschaltungsteil 1 ($f_{R1}$) und für den zweiten PLL-Hilfsschaltungsteil 2 ($f_{R2}$) müssen vom Referenz-Schaltungsteil 5 aus der Referenzfrequenz $f_R$ (geteilte Quarzfrequenz $f_Q$) unter der Maßgabe einer festen Schrittweite $f_{SOUT}$ für die Ausgangsfrequenz $f_{OUT}$ durch zwei dem Frequenzteiler 52 nachgeschaltete parallele Frequenzteiler folgendermaßen erzeugt werden:

$$f_{SOUT} = f_{R1} \cdot N_{34,1} = f_{R2} \cdot N_{34,2}.$$

Somit ergeben sich für die Referenzfrequenzen:

$$f_{R1} = f_{SOUT}/N_{34,1} \text{ und } f_{R2} = f_{SOUT}/N_{34,2},$$

wobei $N_{34,1}$ und $N_{34,2}$ die unterschiedlichen Teilerfaktoren des umschaltbaren Frequenzteilers 34 sind.

**Patentansprüche**

1. Schaltungsanordnung für eine Phasenregelschleife, mit:

   - einem PLL-Hauptschaltungsteil (3) zur Generierung einer phasenstabilen Ausgangsfrequenz ($f_{OUT}$),

   - mindestens zwei PLL-Hilfsschaltungsteilen (1,2) zur Generierung von unterschiedlichen phasenstabilen Alternativfrequenzen ($f_{A1}$, $f_{A2}$) aus mindestens einer gegenüber den Alternativfrequenzen ($f_{A1}$, $f_{A2}$) niedrigeren Referenzfrequenz ($f_R$),

   - einem Referenz-Schaltungsteil (5) zur Erzeugung der mindestens einen Referenzfrequenz ($f_R$) für die PLL-Hilfsschaltungsteile (1, 2)

   - und einem im PLL-Hauptschaltungsteil (3) vorgesehenen Umschaltglied (39) zur Selektion einer der Alternativfrequenzen ($f_{A1}$, $f_{A2}$) als Referenzfrequenz ($f_{R3}$) für den PLL-Hauptschaltungsteil (3),

   dadurch gekennzeichnet,

   - daß der PLL-Hauptschaltungsteil (3) ein schnelleres Einschwingverhalten aufweist als die PLL-Hilfsschaltungsteile (1, 2),

   - daß die PLL-Hilfsschaltungsteile (1, 2) jeweils einen variablen Frequenzteiler (14, 24) aufweisen, deren Teilerfaktoren derart unterschiedlich gewählt werden, daß den Alternativfrequenzen ($f_{A1}$, $f_{A2}$) jeweils unterschiedliche, nichtüberlappende Frequenzbereiche zugeordnet sind,

   - und daß der PLL-Hauptschaltungsteils (3) einen Frequenzteiler (34) aufweist, dessen Teilerfaktor ($N_{34}$) variierbar ist und in Abhängigkeit der Teilerfaktoren der variablen Frequenzteiler (14, 24) derart gewählt wird, daß die Ausgangsfrequenz ($f_{OUT}$) in vorgegebener Schrittweite ($f_{SOUT}$) variierbar ist.

2. Schaltungsanordnung nach Anspruch 1, dadurch gekennzeichnet, daß der PLL-Hauptschaltungsteil (3) aus einem Phasendetektor (30), einem Schleifenfilter (31), einem Schleifenverstärker (32), einem VCO (33), dem Frequenzteiler (34) und dem Umschaltglied (39) besteht, und daß dem Phasendetektor (30) die Referenzfrequenz ($f_{R3}$) für den PLL-Hauptschaltungsteil (3) als Ausgangssignal des Umschaltglieds (39) sowie eine Vergleichsfrequenz ($f_{V3}$) als Ausgangssignal des Frequenzteilers (34) zugeführt werden.

3. Schaltungsanordnung nach Anspruch 1 oder 2, dadurch gekennzeichnet, daß jeder PLL-Hilfsschaltungsteil (1, 2) aus einem Phasendetektor (10, 20) einem Schleifenfilter (11, 21), einem Schleifenverstärker (12, 22), einem VCO (13, 23) und einem der variablen Frequenzteiler (14, 24) besteht, und daß die Ausgangssignale der VCOs (13, 23) jeweils einem Eingang des Umschaltglieds (39) als die phasenstabilen Alternativfrequenzen ($f_{A1}$, $f_{A2}$) zugeführt werden.

4. Schaltungsanordnung nach einem der Ansprüche 1 bis 3, dadurch gekennzeichnet, daß eine Auswerteschaltung (4) zur Betätigung des Umschaltglieds (39) vorgesehen ist, die in Abhängigkeit der Phasenstabilität der Alternativfrequenzen ($f_{A1}$, $f_{A2}$) die Betätigung des Umschaltglieds (39) erst dann ermöglicht, wenn die mit dem Umschaltglied (39) zu selektierende Alternativfrequenz ($f_{A1}$, $f_{A2}$) phasenstabil vorliegt.

5. Schaltungsanordnung nach Anspruch 4 und 3, dadurch gekennzeichnet, daß die Auswerteschaltung (4) einen Schalteingang (FW) zur Vorgabe eines Frequenzwechsels der Ausgangsfrequenz ($f_{OUT}$), für jeden PLL-Hilfsschaltungsteil (1, 2) einen Steuereingang ($PS_1$, $PS_2$) und einen mit einem Steuereingang des Umschaltglieds (39) verbundenen Ausgang zur Betätigung des Umschaltglieds (39) aufweist, daß die PLL-Hilfsschaltungsteile (1, 2) zur Erkennung der Phasenstabilität der Alternativfrequenzen ($f_{A1}$, $f_{A2}$) jeweils einen an den Phasendetektor (10, 20) des jeweiligen PLL-Hilfsschaltungsteils (1, 2) angeschlossen Lock-Detektor (17, 27) oder einen Frequenzzähler aufweisen, und daß die Ausgangssignale ($LD_1$, $LD_2$) der Lock-Detektoren (17, 27) oder der Frequenzzähler den Steuereingängen ($PS_1$, $PS_2$) der Auswerteschaltung (4) zugeführt werden.

**6.** Schaltungsanordnung nach einem der Ansprüche 3 oder 5, bwz. 4 und 3, dadurch gekennzeichnet, daß der Referenz-Schaltungsteil (5) aus einem Quarzoszillator (51) und einem variablen Frequenzteiler (52) besteht, und daß das Ausgangssignal des variablen Frequenzteiler (52) als Referenzfrequenz ($f_R$) einem der Eingänge des Phasendetektors (10, 20) der PLL-Hilfsschaltungsteile (1, 2) zugeführt wird.

**7.** Schaltungsanordnung nach einem der Ansprüche 1 bis 5, dadurch gekennzeichnet, daß der Teilerfaktor ($N_{34}$) des Frequenzteilers (34) des PLL-Hauptschaltuugsteils (3) durch das Umschaltglied (39) steuerbar ist.

**8.** Schaltungsanordnung nach Anspruch 7 und 3, dadurch gekennzeichnet, daß der Referenz-Schaltungsteil (5) aus einem Quarzoszillator (51), einem variablen Frequenzteiler (52) und einem dem variablen Frequenzteiler nachgeschalteten umschaltbaren Frequenzteiler besteht, wobei der umschaltbare Frequenzteiler für jeden PLL-Hilfsschaltungsteil (1, 2) eine eigene Referenzfrequenz ($f_{R1}$, $f_{R2}$) erzeugt, die dem Phasendetektor (10, 20) des jeweiligen PLL-Hilfsschaltungsteils (1, 2) als Eingangssignal zugeführt wird und die jeweils einem der Teilerfaktoren ($N_{34,1}$, $N_{34,2}$) des Frequenzteilers (34) des PLL-Hauptschaltungsteils (3) zugeordnet ist, und daß die Teilerfaktoren des umschaltbaren Frequenzteilers derart gewählt werden, daß die Produkte aus den vom umschaltbaren Frequenzteiler erzeugten Referenzfrequenzen ($f_{R1}$, $f_{R2}$) und den diesen jeweils zugeordneten Teilerfaktoren ($N_{34,1}$, $N_{34,2}$) des Frequenzteilers (34) des PLL-Hauptschaltungsteils (3) gleich sind.

**9.** Schaltungsanordnung nach Anspruch 8, dadurch gekennzeichnet daß der umschaltbare Frequenzteiler als eine Verzweigung aus parallel geschalteten Frequenzteilern realisiert ist.

**10.** Schaltungsanordnung nach einem der Ansprüche 1 bis 9 zur Generierung der Zwischenfrequenzen in einem Rundfunkempfänger.

**11.** Schaltungsanordnung nach Anspruch 10, dadurch gekennzeichnet, daß als Ausgangssignal ($f_{OUT}$) des PLL-Hauptschaltungsteils (3) die FM-Zwischenfrequenz generierbar ist.

**12.** Schaltungsanordnung nach Anspruch 10, dadurch gekennzeichnet, daß als Ausgangssignal eines der PLL-Hilfsschaltungsteile (1 bzw. 2) die AM-Oszillatorfrequenz generierbar ist.

**Claims**

**1.** A circuit arrangement for a phase control loop comprising:

-  a PLL main circuit section (3) for generating a phase-stable output frequency ($f_{OUT}$)

-  at least two PLL sub-circuit sections (1, 2) for generating differing phase-stable alternative frequencies ($f_{A1}$, $f_{A2}$) from at least one reference frequency ($f_R$) which is lower than the alternative frequencies ($f_{A1}$, $f_{A2}$),

-  a reference circuit section (5) for generating said at least one reference frequency ($f_R$) for the PLL sub-circuit sections (1, 2)

-  and a switch-over member (39) provided in the PLL main circuit section (3) for selecting one of the alternative frequencies ($f_{A1}$, $f_{A2}$) as a reference frequency ($f_{R3}$) for the PLL main circuit section (3),

characterised in

-  that the PLL main circuit section (3) exhibits a faster transient response than the PLL sub-circuit sections (1, 2),

-  that the PLL sub-circuit sections (1, 2) comprise a respective variable frequency divider (14, 24) whose division factors are selected differently in a manner such that the alternative frequencies ($f_{A1}$, $f_{A2}$) are disposed in different non-overlapping frequency ranges,

-  and that the PLL main circuit section (3) comprises a frequency divider (34) whose division factor ($N_{34}$) is variable and is selected in dependence on the division factors of the variable frequency dividers (14, 24) in a manner such that the output frequency ($f_{OUT}$) is variable in pre-defined steps ($f_{SOUT}$).

**2.** A circuit arrangement in accordance with Claim 1, characterised in that the PLL main circuit section (3) comprises a phase detector (30), a loop filter (31), a loop amplifier (32), a VCO (33), the frequency divider (34) and the.switch-over member (39), and in that the reference frequency ($f_{R3}$) for the PLL main circuit section (3) is supplied to the phase detector (30) in the form of the output signal from the switch-over member (39) and a comparison frequency ($f_{V3}$) is also supplied thereto in the form of the output signal from the frequency divider (34).

**3.** A circuit arrangement in accordance with Claim 1 or 2, characterised in that each of the PLL sub-circuit sections (1, 2) consists of a phase detector (10, 20), a loop filter (11, 21), a loop amplifier (12, 22), a VCO (13, 23) and one of the variable frequency dividers (14, 24), and in that the output signals from the VCOs (13, 23) are supplied to a respective input of the switch-over member (39) as the phase-stable alternative frequencies ($f_{A1}$, $f_{A2}$).

4. A circuit arrangement in accordance with any of the Claims 1 to 3, characterised in that there is provided an evaluating circuit (4) for actuating the switch-over member (39), said evaluating circuit only enabling the switch-over member (39) to be actuated in dependence on the phase stability of the alternative frequencies ($f_{A1}$, $f_{A2}$) when the alternative frequency ($f_{A1}$, $f_{A2}$) that is to be selected for the switch-over member (39) is phase-stable.

5. A circuit arrangement in accordance with Claim 4 and 3, characterised in that the evaluating circuit (4) comprises a switching input (FW) for issuing a frequency changing command for the output frequency ($f_{OUT}$), a control input ($PS_1$, $PS_2$) for each of the PLL sub-circuit sections (1, 2) and an output connected to a control input of the switch-over member (39) for actuating said switch-over member (39), in that the PLL sub-circuit sections (1, 2) comprise a respective lock detector (17, 27) or a frequency counter connected to the phase detector (10, 20) of the respective PLL sub-circuit section (1, 2) for detecting the phase-stability of the alternative frequencies ($f_{A1}$, $f_{A2}$), and in that the output signals ($LD_1$, $LD_2$) of the lock detectors (17, 27) or the frequency counters are supplied to the control inputs ($PS_1$, $PS_2$) of the evaluating circuit (4).

6. A circuit arrangement in accordance with any of the Claims 3 or 5, or, 4 and 3, characterised in that the reference circuit section (5) consists of a quartz oscillator (51) and a variable frequency divider (52), and in that the output signal of the variable frequency divider (52) is supplied as a reference frequency ($f_R$) to one of the inputs of the phase detector (10, 20) of the PLL sub-circuit sections (1, 2).

7. A circuit arrangement in accordance with any of the Claims 1 to 5, characterised in that the division factor ($N_{34}$) of the frequency divider (34) of the PLL main circuit section (3) is controllable by the switch-over member (39).

8. A circuit arrangement in accordance with Claim 7 and 3, characterised in that the reference circuit section (5) consists of a quartz oscillator (51), a variable frequency divider (52) and a switchable frequency divider connected downstream of the variable frequency divider, whereby the switchable frequency divider produces a unique reference frequency ($f_{R1}$, $f_{R2}$) for each of the PLL sub-circuit sections (1, 2), each said reference frequency being supplied as an input signal to the phase detector (10, 20) of the respective PLL sub-circuit section (1, 2) and being associated with one of the division factors ($N_{34,1}$, $N_{34,2}$) of the frequency divider (34) in the PLL main circuit section (3), and in that the division factors of the switchable frequency divider are selected in a manner such that the products of the reference frequencies ($f_{R1}$, $f_{R2}$) produced by the switchable frequency divider and the respective division factors ($N_{34,1}$, $N_{34,2}$) of the frequency divider (34) in the PLL main circuit section (3) associated therewith are equal.

9. A circuit arrangement in accordance with Claim 8, characterised in that the switchable frequency divider is implemented in the form of a branch network consisting of frequency dividers connected in parallel.

10. A circuit arrangement in accordance with any of the Claims 1 to 9 for generating intermediate frequencies in a radio receiver.

11. A circuit arrangement in accordance with Claim 10, characterised in that the FM intermediate frequency is generatable in the form of the output signal (four) of the PLL main circuit section (3).

12. A circuit arrangement in accordance with Claim 10, characterised in that the AM oscillator frequency is generatable in the form of the output signal of one of the PLL sub-circuit sections (1 or 2).

**Revendications**

1. Montage pour une boucle de régulation de phase comportant

   - un élément de circuit principal (3) de boucle PLL pour produire une fréquence de sortie ($f_{OUT}$) stable du point de vue de la phase,
   - au moins deux éléments de circuit auxiliaires (1,2) de boucle PLL pour produire différentes fréquences alternatives ($f_{A1}$, $f_{A2}$) stables du point de vue de la phase, à partir d'au moins une fréquence de référence ($f_R$) inférieure aux fréquences alternatives ($f_{A1}$, $f_{A2}$),
   - un élément de circuit de référence (5) pour produire la au moins une fréquence de référence ($f_R$) pour les éléments de circuit auxiliaires (1,2) de boucle PLL, et
   - un circuit de commutation (39) prévu dans l'élément de circuit principal (3) de boucle PLL pour sélectionner l'une des fréquences alternatives

$(f_{A1}, f_{A2})$ en tant que fréquence de référence $(f_{R3})$ pour l'élément de circuit principal (3) de boucle PLL,

caractérisé en ce

-   que l'élément de circuit principal (3) de boucle PLL possède un comportement en régime transitoire plus rapide que les éléments de circuits auxiliaires (1,2) de boucle PLL,
-   que les éléments de circuits auxiliaires (1,2) de boucle PLL possèdent des diviseurs de fréquence variables respectifs (14,24), dont les facteurs de division sont choisis différents de telle sorte que des plages respectives différentes de fréquences, non en chevauchement, sont associées aux fréquences alternatives $(f_{A1}, f_{A2})$, et
-   que l'élément de circuit principal (3) de boucle PLL possède un diviseur de fréquence (34), dont le facteur de division $(N_{34})$ est variable et est choisi en fonction des facteurs de division des diviseurs de fréquence variables (14,24) de telle sorte que la fréquence de sortie $(f_{OUT})$ peut être modifiée selon des pas prédéterminés $(f_{SOUT})$.

2.  Montage selon la revendication 1, caractérisé en ce que l'élément de circuit principal (3) de boucle PLL est constitué par un détecteur de phase (30), un filtre de boucle (31), un amplificateur de boucle (32), un oscillateur VCO (33), un diviseur de fréquence (34) et le circuit de commutation (39), et qu'au détecteur de phase (30) sont envoyées la fréquence de référence $(f_{R3})$ pour l'élément de circuit principal (3) de boucle PLL en tant que signal de sortie du circuit de commutation (39) ainsi qu'une fréquence de comparaison $(f_{V3})$ en tant que signal de sortie du diviseur de fréquence (34).

3.  Montage selon la revendication 1 ou 2, caractérisé en ce que chaque élément de circuit auxiliaire (1,2) de boucle PLL est constitué par un détecteur de phase (10,20) possédant un filtre de boucle (11,21), un amplificateur de boucle (12,22), un oscillateur VCO (13,23) et l'un des diviseurs de fréquence variables (14,24), et que les signaux de sortie des oscillateurs VCO (13,23) sont envoyés aux entrées respectives du circuit de commutation (39) en tant que fréquences alternatives $(f_{A1}, f_{A2})$ stables du point de vue de la phase.

4.  Montage selon l'une des revendications 1 à 3, caractérisé en ce qu'il est prévu, pour l'actionnement du circuit de commutation (39), un circuit d'exploitation (4) qui, en fonction de la stabilité de phase des fréquences alternatives $(f_{A1}, f_{A2})$, permet l'actionnement du circuit de commutation (39) uniquement lorsque la fréquence alternative $(f_{A1}, f_{A2})$, qui doit être sélectionnée par le circuit de commutation (39), est présente en étant stable du point de vue de la phase.

5.  Montage selon les revendications 4 et 3, caractérisé en ce que le circuit d'exploitation (4) comporte une entrée de commutation (FW) servant à prédéterminer un changement de la fréquence de sortie $(f_{OUT})$, une entrée de commande $(PS_1, PS_2)$ pour chaque élément de circuit auxiliaire (1,2) de boucle PLL, et une sortie, qui est reliée à une entrée de commande du circuit de commutation (39) et sert à actionner le circuit de commutation (39), que les éléments de circuit auxiliaire (1,2) de boucle PLL comportent chacun, pour l'identification de la stabilité de phase des fréquences alternatives $(f_{A1}, f_{A2})$, un détecteur de verrouillage (17,27), raccordé au détecteur de phase (10,20) de l'élément de circuit auxiliaire respectif (1,2) de boucle PLL, ou un compteur de fréquences, et que les signaux de sortie $(LD_1, LD_2)$ des détecteurs de verrouillage (17,27) ou des compteurs de fréquences sont envoyés aux entrées de commande $(PS_1, PS_2)$ du circuit d'exploitation (4).

6.  Montage selon l'une des revendications 3 ou 5 ou 4 et 3, caractérisé en ce que l'élément de circuit de référence (5) est constitué par un oscillateur à quartz (51) et un diviseur de fréquence variable (52), et que le signal de sortie du diviseur de fréquence variable (52) est envoyé en tant que fréquence de référence $(f_R)$ à l'une des entrées du détecteur de phase (10,20) des éléments de circuit auxiliaire (1,2) de boucle PLL.

7.  Montage selon l'une des revendications 1 à 5, caractérisé en ce que le facteur de division $(N_{34})$ du diviseur de fréquence (34) de l'élément de circuit principal (3) à boucle PLL peut être commandé par le circuit de commutation (39).

8.  Montage selon les revendications 7 et 3, caractérisé en ce que l'élément de circuit de référence (5) est constitué par un oscillateur à quartz (51), un diviseur de fréquence variable (52) et un diviseur de fréquence commutable, branché en aval du diviseur de fréquence variable, le diviseur de fréquence commutable produisant pour chaque élément de circuit auxiliaire (1,2) de boucle PLL une fréquence de référence particulière $(f_{R1}, f_{R2})$, qui est envoyée en tant que signal d'entrée au détecteur de phase (10,20) de chaque élément de circuit auxiliaire respectif (1,2) de boucle PLL et qui est associée respectivement à l'un des facteurs de division $(N_{34,1}, N_{34,2})$ du diviseur de fréquence (34) de l'élément de circuit principal (3) de boucle PLL, et que les facteurs de division du diviseur de fréquence commutable sont choisis de telle sorte que les produits des fréquences de référence ( $f_{R1}$, $f_{R2}$) délivrées par le diviseur de fréquence commutable, par les facteurs de division ($N_{34,1}$, $N_{34,2}$) respectivement associés des diviseurs de fréquence (34) de l'élément de circuit principal (3) de boucle PLL sont égaux.

9. Montage selon la revendication 8, caractérisé en ce que le diviseur de fréquence commutable est réalisé en tant que dérivation constituée de diviseurs de fréquence branchés en parallèle.

10. Montage selon l'une des revendications 1 à 9 servant à produire les fréquences intermédiaires dans un récepteur radio.

11. Montage selon la revendication 10, caractérisé en ce que la fréquence intermédiaire de modulation de fréquence peut être produite en tant que signal de sortie ($f_{OUT}$) de l'élément de circuit principal (3) de boucle PLL.

12. Montage selon la revendication 10, caractérisé en ce que la fréquence d'oscillation de modulation d'amplitude peut être produite en tant que signal de sortie de l'un des éléments de circuit auxiliaires (1 ou 2) de boucle PLL.

FIG. 1

FIG. 2

EP 0 691 747 B1

12